# EUROPEAN PATENT SPECIFICATION

(11) **EP 3 970 246 B1**
(45) Date of publication and mention of the grant of the patent: **31.05.2023**
(21) Application number: 19732297.7
(22) Date of filing: 13.06.2019
(51) Int. Cl.: H01S 5/022, H01S 5/026, H01S 5/028, H01S 5/10, H01S 5/12, H01S 5/125, H01S 5/16

(54) **OPTICAL DEVICE WITH PASSIVE WINDOW**
OPTISCHE VORRICHTUNG MIT PASSIVEM FENSTER
DISPOSITIF OPTIQUE À FENÊTRE PASSIVE

(43) Date of publication of application: 23.03.2022
(73) Proprietor: Huawei Technologies Co., Ltd., Longgang District Shenzhen, Guangdong 518129 (CN)
(72) Inventor: RIHANI, Samir, 80992 Munich (DE); PATE, Malcolm, 80992 Munich (DE); CHEN, Xin, 80992 Munich (DE)
(74) Representative: Körber, Martin Hans
(86) International application number: PCT/EP2019/065578
(87) International publication number: WO 2020/249219

(56) References cited:
- GB-A- 2 432 456
- US-A- 5 539 571
- US-A- 6 052 397
- US-A1- 2002 037 021
- US-A1- 2018 152 001

## Description

### BACKGROUND

This invention relates to optical devices, for example lasers, electroabsorption modulators and semiconductor optical amplifiers.

High-performance and low-cost optical device modules are used in applications such as large-capacity and high-speed optical access networks.

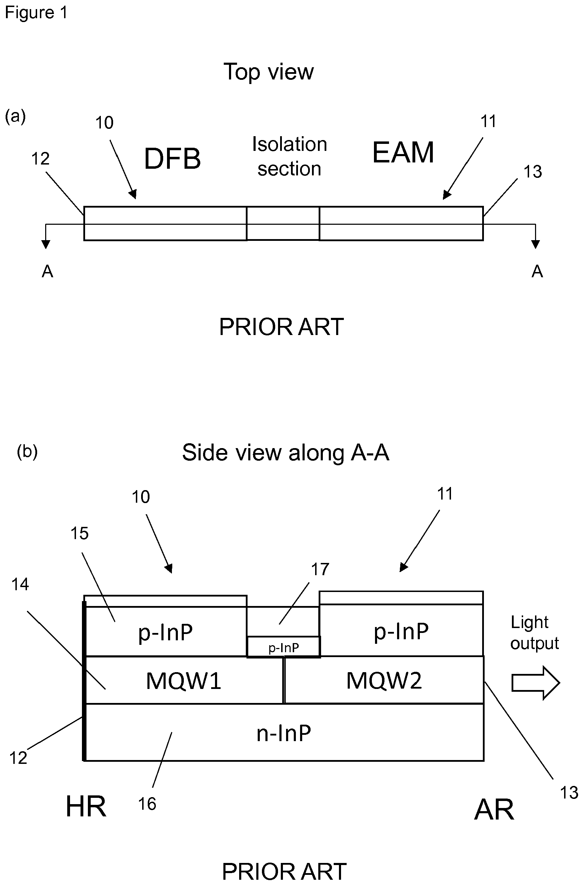

As shown in the example of Figures 1(a) and 1(b), a standard high speed electroabsorption modulated laser (EML) comprises a distributed feedback (DFB) laser 10 and an electroabsorption modulator (EAM) 11. The device generally comprises a semiconductor block which has a rear face or facet 12, a front face or facet 13 opposite to the rear facet and an optical cavity formed therebetween. The cavity traditionally comprises an active layer 14 interposed between layers of p- or n-type semiconductor material, shown at 15 and 16 respectively. One or more coating layers, such as anti-reflection (AR) or high reflection (HR) coatings, may be applied to the front and the rear facets to provide a predetermined reflectivity. In distributed feedback (DFB) lasers, a Bragg grating acts as the wavelength selective element for at least one of the faces and provides feedback, reflecting light back into the cavity to form the resonator. The rear face of the DFB is generally coated with a HR coating. In an EAM, the front facet at the emissive face is generally coated with an AR coating to reduce the facet reflection. In some implementations, an EML may alternatively comprise a distributed Bragg reflector (DBR) laser in place of the DFB laser.

A standard EML, DBR laser, or DFB laser has a constant waveguide width. The grating of the DFB or DBR may be a full grating, a λ/4 grating, or a partial grating. In an EML, the isolation between the laser and EAM is conventionally achieved by etching away the top layer of the substrate by a depth of approximately 1.0 to 2.5 µm, shown at 17, or by ion-implantation.

The HR and AR facets of such devices are both normally formed by cleaving. However, the cleaving process may damage the facet. As a result of cleaving damage, constant current injection and high optical intensity, the rear facet is prone to catastrophic optical mirror damage (HR-COMD) when the DFB or DBR laser is under a high current injection and/or operating at a high temperature.

It is desirable to develop a device that is less prone to such problems.

US 5 539 571 discloses an optical amplifier semiconductor device, which is differentially pumped and a master oscillator power amplifier device employing such an amplifier. An active light emitting region is provided. Further, a transparent window region is formed adjacent to the output facet, which reduces catastrophic optical damage effects.

US 2018/0152001 A1 discloses a semiconductor laser with a waveguide. Hereby, current non-flow regions are respectively formed near the resonator end faces.

Further related prior art is disclosed in US 6 052 397, GB 2 432 456 A and US 2002/0037021 A1.

### SUMMARY OF THE INVENTION

There is provided an optical device having a first face, a second face and an optical cavity, the optical cavity being defined by a semiconductor substrate and having a length extending between the first face and the second face, the device comprising: a waveguide extending with the optical cavity for inducing light in the cavity to travel along the length of the cavity; an active region configured for injection of charge into the cavity, the active region being spaced from the first face; and an inactive region, the inactive region being located between the active region and the first face. The optical device comprises a laser and a modulator and the device may be configured such that the second face is the emissive face of the device. This results in a laser that is less prone to HR-COMD. The laser and the modulator are coupled to one another by a further inactive region. This allows the laser and the modulator to be electrically isolated from one another.

This passive window structure results in a device which may have better cleave quality and which is less prone to cleave damage, has lower optical intensity and reduced heating at the first face. This may help to prevent HR-COMD from occurring in the device.

The waveguide may have a width defined perpendicular to the length of the cavity, wherein the width of the waveguide adjacent to the first face is wider than the average width of the waveguide between the interface between the active region and the inactive region and the second face. This may further improve the performance of the device.

The optical device may comprise a distributed feedback (DFB) laser or a distributed Bragg reflector laser (DBR) laser. This may be a convenient operational format.

The modulator may be an electroabsorption modulator or a Mach-Zehnder modulator. Therefore, the device may allow for the integration of other optically functional structures.

The device may comprise a pair of electrodes disposed on either side of the semiconductor substrate, the device being configured such that light emission can be stimulated from the substrate by applying a current across the electrodes. This is a convenient optical device configuration.

One of the electrodes may be electrically isolated from the inactive region of the cavity. This may prevent current injection in this region of the cavity.

The waveguide may adjoin the active region and the inactive region and the width of a section of the waveguide adjoining the active region at its end closer to the first face may decrease with distance from that end. The remainder of the waveguide adjoining the active region may have substantially constant width. This waveguide configuration is convenient for manufacturing the device.

One or both of the first face and the second face may be constituted by a cleaved facet. This may be convenient for manufacturing the device.

The first face or the second face may be coated with a reflective coating. The first face or the second face may be coated with an anti-reflection coating. This may improve the performance of the device.

The optical cavity may comprise a first semiconductor layer of a first doping type, a second semiconductor layer of a second doping type opposite to the first type, and an active region located between the first and second semiconductor layers, the first and second semiconductor layers being elongated in a direction extending between the first face and the second face. This is a convenient configuration for manufacturing the device.

### BRIEF DESCRIPTION OF THE FIGURES

The present invention will now be described by way of example with reference to the accompanying drawings.

In the drawings:
Figure 1(a) shows a top view of a conventional EML.
Figure 1(b) is a side view along section A-A of Figure 1(a).
Figure 2(a) illustrates a top view of an example of an optical device.
Figure 2(b) is a side view along section B-B of Figure 2(a).
Figure 3(a) illustrates a top view of a further example of an optical device.
Figure 3(b) is a side view along section C-C of Figure 3(a).
Figures 4(a) and 4(b) illustrate the optical mode in a device having a passive section and in a standard DFB/DBR waveguide respectively. These figures illustrate that the optical mode in a device having a passive section has increased the effective mode area of a standard DFB/DBR or EML.
Figures 4(c) and 4(d) are corresponding Scanning Electron Microscopy images of the waveguide structures in a device having a passive window and a standard device respectively.

### DETAILED DESCRIPTION OF THE INVENTION

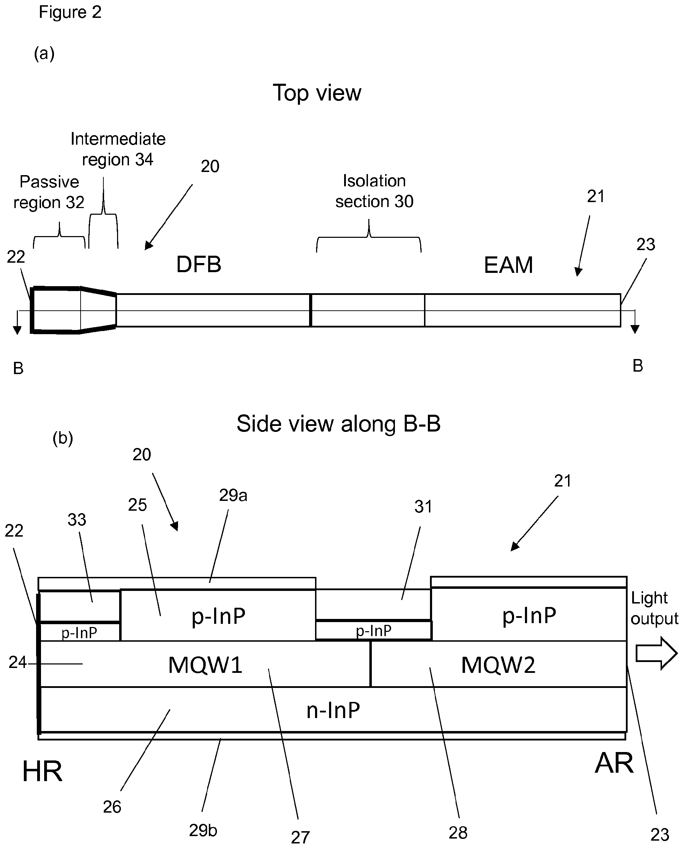

In one exemplary embodiment, as illustrated in Figures 2(a) and 2(b), an EML device comprises a DFB laser 20 and an EAM 21. The DFB laser 20 comprises a semiconductor block which has a rear face 22. The front face 23 of the EML device is opposite to the rear face and an optical cavity is formed therebetween. The front and rear faces may be cleaved facets. It is preferable that the front and rear facets of the device are aligned parallel to one another. A high reflection (HR) coating may be applied to the rear facet. This facet 22 acts as a rear reflector. The front facet 23 at the emissive face of the device is coated with an AR coating to reduce the facet reflection. The grating of the DFB laser (not shown) may be a full grating, λ/4 grating or partial grating.

In the example shown in Figures 2(a) and 2(b), the optical cavity of the EML comprises an active layer 24 interposed between layers of p- and n-type semiconductor material, shown at 25 and 26 respectively. In this example, the semiconductor layers are made from InP. However, other semiconductor materials, such as GaAs, may be used. The material forming the cavity may be selectively doped in the region of the p- and n-type layers 25, 26. The layers 24, 25 and 26 are defined in a substrate. The multiple quantum wells MQW1 and MQW2 in the active region of the device, shown at 27 and 28 respectively, may be identical, or they may be different.

A waveguide, the width profile of which is shown in the top view of Figure 2(a), extends along the optical cavity for inducing light in the cavity to travel along the length of the cavity. The waveguide comprises a material with a refractive index greater than that of the surrounding substrate. Light is emitted from the end of the waveguide at the front face of the device.

The waveguide may be a ridge waveguide. A ridge waveguide may be created by etching parallel trenches in the material either side of the waveguide to create an isolated projecting strip, typically less than 10 µm wide and several hundred µm long. A material with a lower refractive index than the waveguide material can be deposited at the sides of the ridge to guide injected current into the ridge. Alternatively, the ridge may be surrounded by air on the three sides that are not in contact with the substrate beneath the waveguide. The ridge may also be coated with gold to provide electrical contact and to assist heat removal from the ridge when it is producing light.

Alternatively, the waveguide may be a buried heterostructure waveguide.

The device comprises a pair of electrodes 29a, 29b disposed on either side of the semiconductor substrate. The device is configured such that light emission can be stimulated from the substrate by applying a current across the electrodes.

A butt-couple joint may be used to join the DFB and EAM. The DFB and EMA are separated by an isolation section, shown at 30 in Figure 2(a). The top surface of the p-InP semiconductor substrate is etched away in this region, as shown at 31 in Figure 2(b). In this isolation section 30, there is no current injection into the device and the DFB and EAM are electrically isolated from one another. The length of the isolation section may be from approximately 40 to 100 µm and the etch depth in this section from the top of the semiconductor substrate may be approximately 0.8 to 2.0 µm.

Adjacent to the rear face 22 of the device, which in this example is coated with the HR coating, there is a region 32 where there is no current injection into the device. i.e. this section 32 is a passive region of the device.

The device also comprises an active region configured for injection of charge into the cavity. In the active region, light emission is stimulated from the device by applying a current across the electrodes 29a, 29b, which are in electrical contact with the substrate in the active region. In the embodiment of Figure 2, the passive window region 32 is adjacent to the rear face 22 and the active region in which charge injection occurs is spaced from the rear face 22.

The inactive (i.e. passive) region 32 is located between the active region and the rear face. There is no injection of charge into the cavity in this region. The length of the passive waveguide section may be between approximately 10 to 40 µm.

In this example, as shown at 33, the substrate of the passive section 32 of the laser waveguide is etched away by 0.5 to 2.5 µm from the top of the substrate, more preferably by 1.0 to 1.5 µm, to prevent current injection into the passive section from the upper electrode 29a. The etched-away top layers can be filled with SiO₂, BCB, or SiOₓN_{y}. Alternatively, the top of the substrate in the passive section may be removed by ion-implantation.

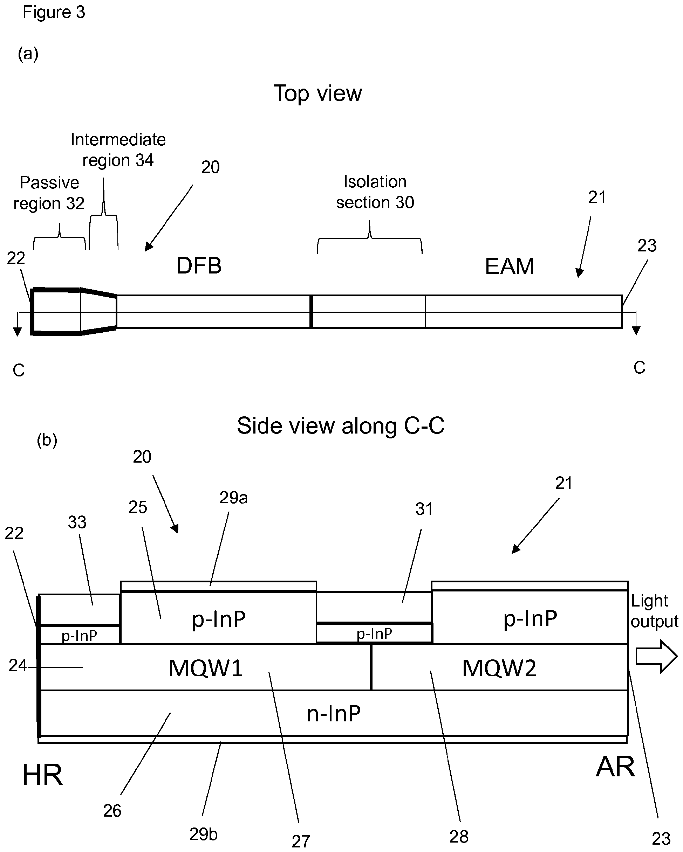

In the embodiment of Figures 2(a) and 2(b), the top contact metal electrode 29a covers the passive section and the substrate is etched away beneath it, such that the electrode and the passive section are electrically isolated in this region and current injection into the passive region does not occur. However, in the alternative embodiment of Figures 3(a) and 3(b), the passive section is left uncovered and there is no electrode covering the passive region 32 region at the top of the substrate (i.e. the electrode 29a does not extend to cover the passive region), as shown in the side view of Figure 3(b).

In the particularly advantageous embodiments of Figures 2 and 3, the passive section 32 of the laser waveguide adjacent to the front face is widened, as illustrated in the plan views of Figures 2(a) and 3(a). In the passive region 32, the waveguide may have a width of approximately 3.5 to 10 µm, or more preferably 3.5 to 30 µm (in contrast to a standard DFB waveguide width of approximately 1.3 to 3.0 µm). The length of this passive widened section of the waveguide is between approximately 5 to 50 µm.

An intermediate section of the waveguide 34 which couples the first, passive, part of the waveguide 32 to the second, active, part of the waveguide has a varying width, w, along its length. The width of the waveguide is measured parallel to its length. The intermediate section 34 joining the standard DFB waveguide and the expanded waveguide section may gradually linearly increase in width, such that the width of the intermediate section of the waveguide at its end closer to the rear face of the device decreases with distance from that end. For example, the width may increase from 1.5 to 2.5 µm to 3.5 to 10 µm. The length of this intermediate part may be between approximately 10 to 50 µm.

Therefore, at the rear face of the device, a passive waveguide section with a wider width and a transition section between the passive waveguide section of wider width and the normal DFB waveguide section are employed.

Furthermore, the top p-InP layers are etched away between the DFB and the EAM to achieve electrical isolation between the DFB and the EAM. The top p-InP layers of the passive waveguide section 32 are also etched away to prevent current injection in the passive section of the device.

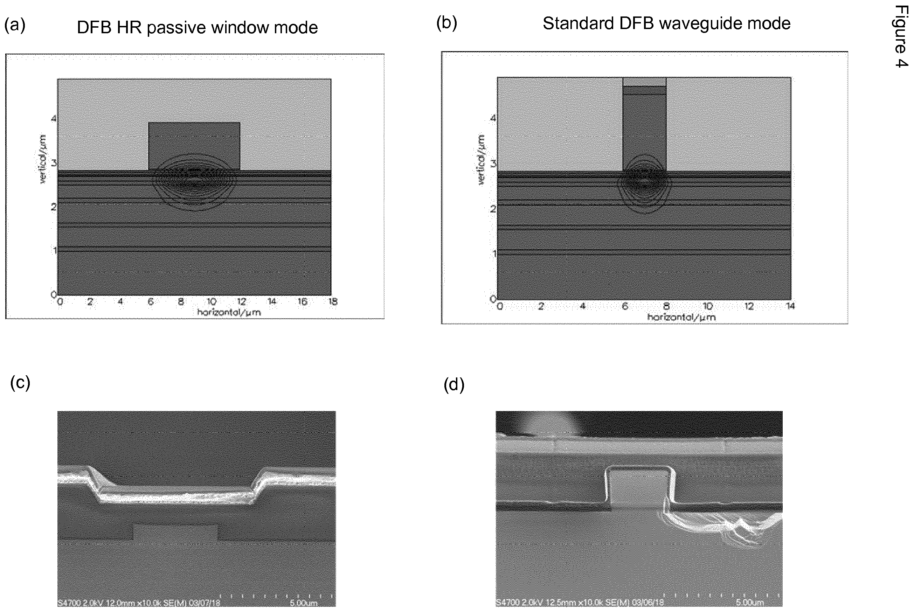

As shown in Figures 4(a)-(d), the optical mode in the passive section has approximately double the effective mode area of a standard DFB or EML. The optical mode in the passive section does not "see" the waveguide boundaries. Therefore, it is less prone to HR-COMD.

Therefore, the rear section of the waveguide, which is adjacent to the HR facet of the device, is modified such that the rear HR facet has better cleave quality and is less prone to cleave damage. There is no current injection in this section of the device, and the optical density at the rear HR facet is lower than in conventional devices. As such, most of the potential causes of HR-COMD are removed (these being current, facet damage, lower optical intensity and heat at the HR facet).

Fabrication of the proposed EML or DFB/DBR device with a passive waveguide section does not require any extra process steps to the methods of manufacture of standard devices. Therefore, no fabrication process changes from current fabrication techniques are required.

The proposed changes make an EML device chip more tolerant to cleaving damage such that the proposed device may have improved cleaved facet quality, as well as giving it a wide fabrication tolerance. This may improve the reliability of manufacturing of such devices.

No detrimental effect has been observed on the performance of the EML.

The optical device may be integrated with further optically functional structures. For example, a Mach-Zehnder modulator, or an amplifier.

In a further exemplary embodiment, a passive waveguide section may be positioned adjacent to the front (output) facet of an optical device. For example, an optical device may incorporate a semiconductor optical amplifier at its output to boost the light signal before emission from the device. It may be beneficial for the front output facet of the device, which is preferably coated with an AR coating, to have a passive waveguide section, as described above, located adjacent to the output (emissive) facet at the front of the device.

In one exemplary embodiment, the sequence of components (from entry to exit of the light signal) may be: a DFB laser, an EA modulator, an SOA. In this case, light is emitted from the second (i.e. front) face of the integrated device. The waveguide at the EAM or EAM/SOA section may be straight or curved. Therefore, a device comprising an SOA may have a passive window located adjacent to its emissive face. This may be in addition to a passive window located adjacent to the rear face of the DFB laser with which the SOA is optically coupled. Thus, the same passive wider window structure that is employed at the first face can be applied at the second face for an optical device configuration comprising an SOA.

In this embodiment, the presence of the wider passive waveguide structure at the front (AR) facet of the device may improve the facet cleave quality, reduce the optical reflection at the facet, and reduce the front (AR) facet failure.

## Claims

1. An optical device having a first face, a second face and an optical cavity (24, 25, 26), the optical cavity (24, 25, 26) being defined by a semiconductor substrate and having a length extending between the first face (22) and the second face (23), the device comprising:
a waveguide extending with the optical cavity (24, 25, 26) for inducing light in the cavity (24, 25, 26) to travel along the length of the cavity(24, 25, 26);
an active region (24) configured for injection of charge into the cavity (24, 25, 26), the active region (24) being spaced from the first face (22); and
an inactive region (32), the inactive region (32) being located between the active region (24) and the first face (22)
wherein the optical device comprises a laser (20) and a modulator (21) wherein the laser (20) and the modulator (21) are coupled to one another by a further inactive region (30), and wherein the device is configured such that the second face (23) is the emissive face of the device.

2. An optical device as claimed in claim 1, wherein the waveguide has a width defined perpendicular to the length of the cavity (24, 25, 26) and wherein the width of the waveguide adjacent to the first face (22) is wider than the average width of the waveguide between the interface between the active region (24) and the inactive region (32) and the second face (23).

3. The optical device of claim 1, wherein the laser (20) is a distributed feedback (DFB) laser or a distributed Bragg reflector laser (DBR), laser.

4. The optical device of claim 1, wherein the modulator (21) is an electroabsorption modulator or a Mach-Zehnder modulator.

5. The optical device of any preceding claim, the device comprising a pair of electrodes (29a) disposed on either side of the semiconductor substrate, the device being configured such that light emission can be stimulated from the substrate by applying a current across the electrodes (29a).

6. The optical device of claim 5, wherein one of the electrodes (29a) is electrically isolated from the inactive region (32) of the cavity (24, 25, 26).

7. The optical device of any preceding claim, wherein the waveguide adjoins the active region (24) and the inactive region (32) and the width of a section of the waveguide adjoining the active region (24) at its end closer to the first face (22) decreases with distance from that end.

8. The optical device of claim 7, wherein the remainder of the waveguide adjoining the active region (24) has substantially constant width.

9. The optical device of any preceding claim, wherein one or both of the first face (22) and the second face (23) is/are constituted by a cleaved facet.

10. The optical device of claim 8, wherein the first face (22) or the second face (23) is coated with a reflective coating.

11. The optical device of any preceding claim, wherein the optical cavity (24, 25, 26) comprises a first semiconductor layer of a first doping type, a second semiconductor layer of a second doping type opposite to the first type, and an active region located between the first and second semiconductor layers, the first and second semiconductor layers being elongated in a direction extending between the first face (22) and the second face (23).

## Patentansprüche

1. Optische Vorrichtung, die eine erste Fläche, eine zweite Fläche und einen optischen Hohlraum (24, 25, 26) aufweist, wobei der optische Hohlraum (24, 25, 26) durch ein Halbleitersubstrat definiert wird und eine Länge aufweist, die sich zwischen der ersten Fläche (22) und der zweiten Fläche (23) erstreckt, wobei die Vorrichtung umfasst:
einen Wellenleiter, der sich mit dem optischen Hohlraum (24, 25, 26) erstreckt, um Licht in den Hohlraum (24, 25, 26) zu induzieren, dass sich entlang des Hohlraums (24, 25, 26) ausbreitet;
ein aktives Gebiet (24) das für eine Injektion einer Ladung in den Hohlraum (24, 25, 26) konfiguriert ist, wobei das aktive Gebiet (24) von der ersten Fläche (22) beabstandet ist, und
ein inaktives Gebiet (32), wobei das inaktive Gebiet (32) zwischen dem ersten aktiven Gebiet (24) und der ersten Fläche (22) angebracht ist,
wobei die optische Vorrichtung einen Laser (20) und einen Modulator (21) umfasst, wobei der Laser (20) und der Modulator (21) durch ein weiteres inaktives Gebiet (30) miteinander verbunden sind, und wobei die Vorrichtung so konfiguriert ist, dass die zweite Fläche (23) die abstrahlende Fläche der Vorrichtung ist.

2. Optische Vorrichtung nach Anspruch 1, wobei der Wellenleiter eine Breite aufweist, die senkrecht zur Länge des Hohlraums (24, 25, 26) definiert ist, und wobei die Breite des Wellenleiters in der Nähe der ersten Fläche (22) breiter als die durchschnittliche Breite des Wellenleiters zwischen der Grenzfläche zwischen dem aktiven Gebiet (24) und dem inaktiven Gebiet (32) und der zweiten Fläche (23) ist.

3. Optische Vorrichtung nach Anspruch 1, wobei der Laser (20) ein Laser mit verteilter Rückkopplung (Distributed Feedback laser, DFB-Laser) oder ein Laser mit einem verteilten Bragg-Reflektor (Distributed Bragg Reflector laser, DBR-Laser) ist.

4. Optische Vorrichtung nach Anspruch 1, wobei der Modulator (21) ein Elektroabsorptionsmodulator oder ein Mach-Zehnder-Modulator ist.

5. Optische Vorrichtung nach einem der vorhergehenden Ansprüche, wobei die Vorrichtung ein Paar Elektroden (29a) umfasst, die auf beiden Seiten eines Halbleitersubstrats angebracht sind, wobei die Vorrichtung so konfiguriert ist, dass eine Lichtabstrahlung von dem Substrat stimuliert werden kann, indem ein Strom über die Elektroden (29a) angelegt wird.

6. Optische Vorrichtung nach Anspruch 5, wobei eine der Elektroden (29a) von dem inaktiven Gebiet (32) des Hohlraums (24, 25, 26) elektrisch isoliert ist.

7. Optische Vorrichtung nach einem der vorhergehenden Ansprüche, wobei der Wellenleiter an das aktive Gebiet (24) und an das inaktive Gebiet (32) angrenzt und wobei die Breite eines Abschnitts des Wellenleiters, der an seinem näher an der ersten Fläche (22) befindlichen Ende an das aktive Gebiet (24) angrenzt, mit dem Abstand von diesem Ende abnimmt.

8. Optische Vorrichtung nach Anspruch 7, wobei der verbleibende Abschnitt des Wellenleiters, der an das aktive Gebiet (24) angrenzt, eine im Wesentlichen konstante Breite aufweist.

9. Optische Vorrichtung nach einem der vorhergehenden Ansprüche, wobei eine oder beide der ersten Fläche (22) und der zweiten Fläche (23) aus einer gespaltenen Facette bestehen.

10. Optische Vorrichtung nach Anspruch 8, wobei die erste Fläche (22) oder die zweite Fläche (23) mit einer reflektierenden Beschichtung beschichtet ist.

11. Optische Vorrichtung nach einem der vorhergehenden Ansprüche, wobei der optische Hohlraum (24, 25, 26) umfasst: eine erste Halbleiterschicht, die einen ersten Dotierungstyp aufweist, eine zweite Halbleiterschicht, die einen zweiten Dotierungstyp aufweist, der sich von dem ersten Typ unterscheidet, und ein aktives Gebiet, das zwischen der ersten und der zweiten Halbleiterschicht angebracht ist, wobei die erste und die zweite Halbleiterschicht in einer Richtung langgestreckt sind, die sich zwischen der ersten Fläche (22) und der zweiten Fläche (23) erstreckt.

## Revendications

1. Dispositif optique ayant une première face, une seconde face et une cavité optique (24, 25, 26), la cavité optique (24, 25, 26) étant définie par un substrat semi-conducteur et ayant une longueur s'étendant entre la première face (22) et la seconde face (23), le dispositif comprenant :
un guide d'ondes s'étendant avec la cavité optique (24, 25, 26) pour induire la lumière dans la cavité (24, 25, 26) à se déplacer le long de la longueur de la cavité (24, 25, 26) ;
une région active (24) configurée pour l'injection de charge dans la cavité (24, 25, 26), la région active (24) étant espacée de la première face (22) ; et
une région inactive (32), la région inactive (32) étant située entre la région active (24) et la première face (22),
dans lequel le dispositif optique comprend un laser (20) et un modulateur (21), le laser (20) et le modulateur (21) étant couplés l'un à l'autre par une autre région inactive (30), et dans lequel le dispositif est configuré de telle sorte que la seconde face (23) soit la face émissive du dispositif.

2. Dispositif optique selon la revendication 1, dans lequel le guide d'ondes a une largeur définie perpendiculairement à la longueur de la cavité (24, 25, 26), et dans lequel la largeur du guide d'ondes adjacent à la première face (22) est plus large que la largeur moyenne du guide d'ondes entre l'interface entre la région active (24) et la région inactive (32) et la seconde face (23).

3. Dispositif optique selon la revendication 1, dans lequel le laser (20) est un laser à rétroaction distribuée (DFB) ou un laser à réflecteur de Bragg distribué, DBR.

4. Dispositif optique selon la revendication 1, dans lequel le modulateur (21) est un modulateur à électro-absorption ou un modulateur Mach-Zehnder.

5. Dispositif optique selon l'une quelconque des revendications précédentes, le dispositif comprenant une paire d'électrodes (29a) disposées de chaque côté du substrat semi-conducteur, le dispositif étant configuré de telle sorte que l'émission de lumière puisse être stimulée à partir du substrat en appliquant un courant aux bornes des électrodes (29a).

6. Dispositif optique selon la revendication 5, dans lequel l'une des électrodes (29a) est isolée électriquement de la région inactive (32) de la cavité (24, 25, 26).

7. Dispositif optique selon l'une quelconque des revendications précédentes, dans lequel le guide d'ondes est contigu à la région active (24) et à la région inactive (32), et la largeur d'une section du guide d'ondes contiguë à la région active (24) à son extrémité la plus proche de la première face (22) diminue avec la distance à partir de cette extrémité.

8. Dispositif optique selon la revendication 7, dans lequel le reste du guide d'ondes contigu à la région active (24) a une largeur sensiblement constante.

9. Dispositif optique selon l'une quelconque des revendications précédentes, dans lequel l'une ou les deux de la première face (22) et de la seconde face (23) sont constituées par une facette clivée.

10. Dispositif optique selon la revendication 8, dans lequel la première face (22) ou la seconde face (23) est revêtue d'un revêtement réfléchissant.

11. Dispositif optique selon l'une quelconque des revendications précédentes, dans lequel la cavité optique (24, 25, 26) comprend une première couche semi-conductrice ayant un premier type de dopage, une seconde couche semi-conductrice ayant un second type de dopage opposé au premier type, et une région active située entre les première et seconde couches semi-conductrices, les première et seconde couches semi-conductrices étant allongées dans une direction s'étendant entre la première face (22) et la seconde face (23).
